Europäisches Patentamt

(19) European Patent Office

Office européen des brevets

(11) Numéro de publication: **0 242 285 B1**

## (12) FASCICULE DE BREVET EUROPEEN

(45) Date de publication du fascicule du brevet:
21.03.90

(21) Numéro de dépôt: 87400818.8

(22) Date de dépôt: 10.04.87

(51) Int. Cl.⁴: **G01N 33/38**

(54) Dispositif de fixation et de réglage d'un mandrin porteur de bobines de gradient.

(30) Priorité: 15.04.86 FR 8605364

(43) Date de publication de la demande:
21.10.87 Bulletin 87/43

(45) Mention de la délivrance du brevet:
21.03.90 Bulletin 90/12

(84) Etats contractants désignés:
DE GB NL

(56) Documents cités:
EP-A- 0 152 588
FR-A- 2 557 351

**PATENT ABSTRACTS OF JAPAN,**
vol. 9, no. 86 (P-349)(1809), 16 avril 1985; &
JP-A-59 216 045 (HITACHI SEISAKUSHO
K.K.) 06-12-1984

(73) Titulaire: **GENERAL ELECTRIC CGR S.A., 100, rue
Camille-Desmoulins, F-92130 Issy les Moulineaux(FR)**

(72) Inventeur: **Sireul, Jacques, THOMSON-CSF
SCPI 19, avenue de Messine, F-75008 Paris(FR)**
Inventeur: **Prevot, Claude, THOMSON-CSF
SCPI 19, avenue de Messine, F-75008 Paris(FR)**
Inventeur: **Rigeade, Bernard, THOMSON-CSF
SCPI 19, avenue de Messine, F-75008 Paris(FR)**

(74) Mandataire: **Ballot, Paul Denis Jacques et al, Cabinet
Ballot-Schmit 7, rue le Sueur, F-75116 Paris(FR)**

ACTORUM AG

## Description

L'invention a pour objet un dispositif de fixation et de réglage d'un mandrin porteur de bobines de gradient à l'intérieur de l'aimant d'un appareil de mesure de la résonance magnétique nucléaire. Elle trouve particulièrement son application dans le domaine médical où des aimants et des mandrins porteurs de bobines de gradient de grandes tailles sont utilisés. Elle concerne parmi ces appareils de mesure plus particulièrement ceux qui ont pour vocation de faire de l'imagerie par résonance magnétique nucléaire (IRM) sur des corps humains. L'état de la technique est montré dans les documents: FR-A 2 557 351 et EP-A 152 588.

Un appareil de mesure de la résonance magnétique nucléaire comporte essentiellement un aimant pour soumettre un corps à examiner à un champ magnétique continu homogène et intense $B_0$. Cet aimant a généralement une forme cylindrique circulaire. Typiquement la longueur de ce cylindre est de quelques mètres (2,5 m) et laisse libre un volume intérieur cylindrique circulaire d'examen dont le diamètre est de l'ordre du mètre. La correction d'homogénéité du champ est ordinairement obtenue par adjonction de bobines de correction, dites de shim, concentriques à l'aimant et placées à l'intérieur de l'aimant mais le plus près possible de la face intérieure de cet aimant. De cette manière on laisse libre un plus grand volume d'examen. Pour différencier des régions de l'espace du volume d'examen, en particulier pour faire de l'imagerie, il est connu de disposer à l'intérieur des bobines de shim un mandrin porteur de bobines dites de gradient. Les bobines de gradient introduisent une perturbation du champ qui est calibrée et dont la répartition selon des axes de mesure est connue. Le mandrin dit de gradient porteur des bobines de gradient est placé à l'intérieur de l'ensemble des bobines de shim. Il s'appuie sur elles. Dans le volume laissé libre à l'intérieur du mandrin de gradient est encore disposée une antenne radiofréquence destinée à provoquer un basculement de l'orientation des moments magnétiques des particules du corps sous examen. Ce basculement est obtenu par émission d'une impulsion d'excitation. L'antenne sert aussi à mesurer le signal de retour à l'équilibre émis par ces particules quand leur moment magnétique tend à se réaligner parallèlement au champ orientateur $B_0$. Pour diverses raisons les antennes radiofréquence, placées à l'intérieur du mandrin de gradient, en sont séparées par un écran tendant à empêcher l'amortissement de l'impulsion radiofréquence dans les bobines de gradients. Cet amortissement en amoindrit en effet l'efficacité. Sans cet écran l'impulsion peut par ailleurs perturber le fonctionnement des bobines de gradient. Dans l'espace laissé libre à l'intérieur de cet empilement concentrique se trouve enfin le corps à examiner. Classiquement dans le domaine médical l'espace cylindrique utile pour l'examen a un diamètre un peu supérieur à 0,50 m.

Parmi tous ces moyens, la concentricité de trois d'entre-eux doit être particulièrement soignée. Il s'agit de l'ensemble des bobines de shim, du mandrin de gradient et de l'aimant. Du fait de la concentricité il est connu de mettre en place chacune des bobines en utilisant comme référence l'ensemble des bobines qui l'entoure. Ainsi les bobines de shim s'appuient sur la face intérieure de l'aimant, le mandrin de gradient s'appuie sur la face intérieure des bobines de shim, l'écran est plaqué sur la face intérieure du mandrin du gradient, enfin les bobines radiofréquence sont accrochées après l'écran. Il s'avère à l'usage que cette manière de faire présente deux inconvénients.

Premièrement, au cours d'un examen RMN, les gradients de champ magnétique utilisés sont imposés en des séquences pulsées. Ils sont établis, ils persistent quelques instants (quelques millisecondes), puis ils sont coupés. Les conducteurs de ces bobines de gradient, qui sont soumis lors de l'établissement et de la coupure du courant à des courants d'intensité variables et qui par ailleurs baignent dans un champ magnétique constant (le champ orientateur $B_0$) sont alors soumis selon la loi de Laplace à des efforts tendant à les faire vibrer. Ces vibrations se répercutent dans toute la chaine concentrique et principalement dans les bobines de shim dont le poids est du même ordre que celui du mandrin de gradient. Il en résulte que l'examen de RMN est bruyant. Des bruits de l'ordre de 90dB peuvent même dans certains cas être enregistrés. Les vibrations sont en outre transmises jusqu'à l'aimant lui même bien qu'il pèse plusieurs tonnes. Elles y provoquent des stimulations néfastes. En particulier si cet aimant est un aimant supraconducteur il en résulte une augmentation de la consommation de son fluide réfrigérant.

D'autre part, lors de l'installation et du réglage des différentes parties de l'appareil, du fait de l'empilement, le réglage d'une des parties entraine le déréglage ou la modification de réglage de la position des autres parties. Or la nature de la perturbation apportée par les gradients est linéaire selon des axes prédéterminés de mesure. Il est alors généralement admis de réduire le nombre des bobines de shim en utilisant les bobines de gradient comme premier ordre de correction de l'homogénéité du champ orientateur. Il suffit tout simplement de faire passer dans ces bobines de gradient un courant continu, un offset de gradient, dont l'intensité dépend de la correction à obtenir. Il en résulte que la précision du réglage de la position du mandrin de gradient devient cruciale puisque les bobines de gradient participent à la correction d'homogénéité du champ orientateur. L'obtention d'un bon calage de ce mandrin de gradient à l'intérieur des bobines de shim n'est alors obtenu qu'après de longues et fastidieuses opérations de réglage mécanique.

L'invention a pour objet de remédier aux inconvénients cités en supprimant l'empilage des références et en proposant des dispositifs de fixation tels que le mandrin de gradient prenne appui directement sur l'aimant (et non plus sur l'ensemble des bobines de shim interposées). De ce fait la transmission des vibrations mécaniques du mandrin de gradient à l'ensemble des bobines de shim s'en trouve supprimée. En conséquence les bobines de shim ne se mettent plus à vibrer. Il en résulte que la masse en vibration venant secouer l'aimant est amoindrie. Elle est réduite à la masse du mandrin de gradient. Ceci provoque la réduction du bruit audible émis et la réduction de la consommation de fluide réfrigérant. Par ailleurs, le réglage des différentes pièces est amélioré. En effet chacune s'appuie maintenant sur une même référence rigide : l'aimant lui-même. En outre le dispositif de maintien du mandrin de gradient peut alors comporter un amortisseur, en série, spécifiquement étudié pour amortir les vibrations intrinsèques du mandrin de gradient. Il est quasiment impossible par contre de concevoir un amortisseur pour réduire les vibrations composites de l'ensemble mandrin de gradient - bobines de shim dans l'état de la technique cité.

L'invention concerne donc un dispositif de fixation et de réglage d'un mandrin porteur de bobines de gradient à l'intérieur d'un aimant, en forme générale de tube, d'un appareil de mesure de la résonance magnétique nucléaire, caractérisé en ce qu'il comporte deux jeux de potences identiques, distribuées et fixées radialement par leur mât de part et d'autre sur des couronnes extrêmes du tube de l'aimant, chaque potence étant munie dans son bras de moyen de mise en contrainte du mandrin.

L'invention sera mieux comprise à la lecture de la description qui suit et à l'examen des figures qui l'accompagnent. Celles-ci ne sont données qu'à titre indicatif et nullement limitatif de l'invention. Sur les figures les mêmes repères désignent les mêmes éléments. Elles représentent :

- figure 1, une représentation schématique de l'architecture des moyens mis en oeuvre dans un appareil d'imagerie par résonance magnétique nucléaire selon l'invention ;
- figure 2, une représentation détaillée en coupe d'une partie d'un dispositif conforme à l'invention ;
- figure 3, une vue de face, selon une direction D de la figure 2, d'une potence du dispositif de fixation selon l'invention.

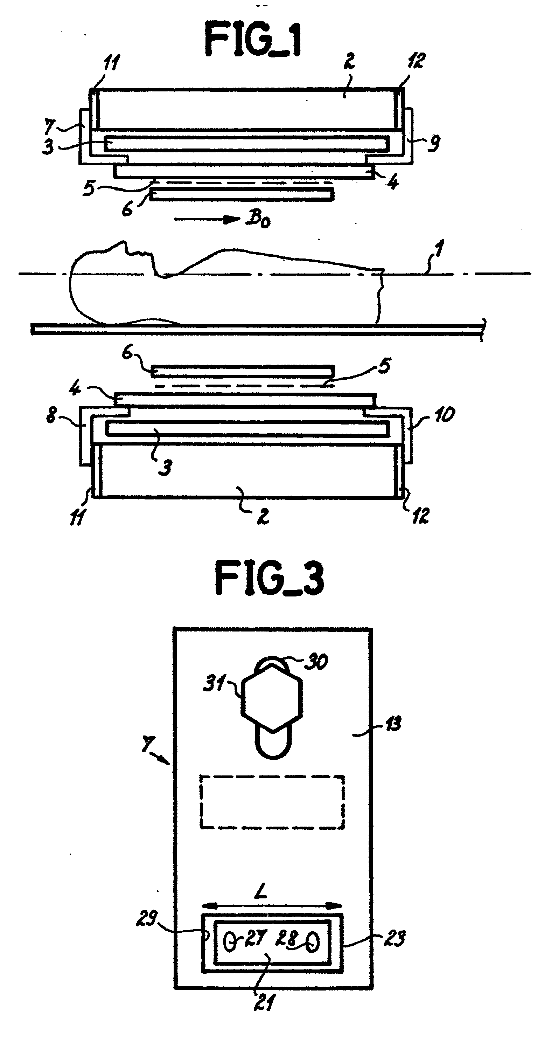

La figure 1 représente schématiquement en coupe diamétrale un appareil d'imagerie par résonance magnétique nucléaire. Autour d'un axe de révolution 1 sont ainsi placés, de l'extérieur vers l'intérieur, un aimant 2 produisant le champ orienteur $B_0$, l'ensemble 3 des bobines de shim, un mandrin de gradient 4, un écran 5 et l'antenne radiofréquence 6. Les liaisons fonctionnelles qui organisent le fonctionnement de ces différents moyens ne sont pas représentées : elles ne concernent pas l'invention. Pour le maintien du mandrin 4 le dispositif de fixation de l'invention comporte deux jeux 7-8 et 9-10 de potences identiques fixées sur des couronnes extrêmes respectivement 11 et 12 de part et d'autre de l'aimant 2. Les jeux 7-8 et 9-10 ne contiennent, bien entendu, pas que les deux seules potences représentées. Ils peuvent en contenir plusieurs. Dans un exemple préféré ils en contiennent chacun 6, elles sont distribuées circulairement sur les couronnes.

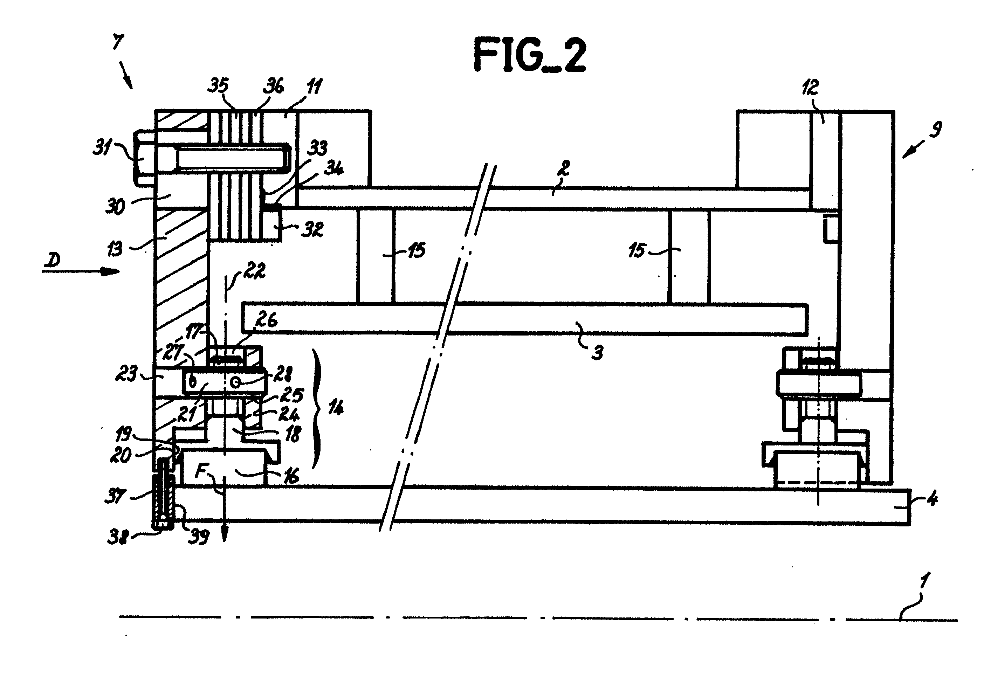

La figure 2 montre en détail comment sont fixées les potences sur les couronnes extrêmes de l'aimant. Le mât de ces potences, par exemple le mât 13 de la potence 7, est orienté radialement. Il s'élève vers l'intérieur de l'aimant en direction de l'axe 1. Le bras 14 de la potence comporte alors un dispositif destiné à exercer une contrainte radiale sur le mandrin de gradient 4. Dans le cas présent la contrainte est une contrainte en compression. On peut constater que la présence des potences permet de rendre la fixation du mandrin 4 à l'aimant 2 indépendante de la fixation, schématiquement représentée 15, des bobines de shim à l'aimant.

Les moyens 14 de mise en contrainte du mandrin de gradient comportent, pour chaque potence, un patin 16 emmené par une extrémité d'une tige filetée 17. La tige 17 est maintenue fixe en rotation par rapport au mât de la potence. Par exemple la tige filetée 17 est solidaire d'un porte-patin 18 dont une des faces latérales planes 19 vient s'appuyer sur une face plane en regard 20 du mât 13 : ceci l'empêche de tourner. La tige filetée peut cependant se déplacer en direction de l'axe 1 par glissement de la face 19 sur la face 20. A cet effet la tige filetée 17 est engagée dans une molette filetée de manoeuvre 21. Cette molette est libre en rotation autour de l'axe 22 de la tige 17, mais elle est maintenue en translation par une encoche 23 pratiquée dans le mât 13. Le porte-à-faux composé de la tige 17 et du patin 16 constitue le bras de la potence 7. Le maintien radialement à l'aimant, de la molette 21 dans l'encoche 23 est obtenu par la présence d'une encoche 25 réalisée de l'autre côté, dans un retour de mât solidaire du mât 13. Le retour de mât 24 est fixé par tous moyens au mât 13, notamment il constitue avec celui-ci un ensemble monobloc. Il y est relié par des liaisons telles que 26. L'encoche 25 a, dans le retour de mât 24, des dimensions égales à l'encoche 23 dans le mât 21. La molette 21 s'appuie alors par ses faces planes circulaires sur les bords des encoches. Par réaction, elle peut entraîner la tige filetée 17 lorsqu'elle est manoeuvrée. Dans un exemple le pas de filetage de la tige filetée 17 vaut 0,5 mm. A chaque tour entier de la molette la tige filetée 17 se déplace donc d'une hauteur radiale égale à ce pas. De manière à permettre la manipulation aisée de la molette, et de manière à quantifier par des sous-multiples du pas le déplacement de la tige, la molette 21 est pourvue de trous tels que 27 et 28 régulièrement répartis sur son pourtour. On peut engager l'extrémité d'une tige de manoeuvre dans ces trous et exercer un couple pour faire tourner la molette. D'une manière préférée la largeur L (figure 3) de l'encoche 23 du mât 7 est suffisante pour que l'on puisse y voir au moins deux trous quand un de ces trous est proche d'une des faces latérales de l'encoche.

Les aimants fabriqués par différents constructeurs d'aimants sont de tailles variables à quelques centimètres près, bien qu'ils respectent des dimensions intérieures communes. De manière à tenir compte des variations, les mâts des potences sont munis d'un trou oblong 30 qui permet un léger débattement de la potence en hauteur. Il en résulte que la cote de fixation de la potence 7 par un boulon 31 dans la couronne 11 n'est pas tributaire de la variation de la position du filet récepteur réalisé par le constructeur de l'aimant dans la couronne extrême 11. Cependant de manière à conserver la nature de référence proposée par cette couronne extrême il est prévu de munir la potence d'un talon 32, fixé au mât de la potence, pour former avec ce mât un réceptacle anguleux dans lequel les faces de références 33 et 34 de la couronne 11 viennent s'imbriquer. Pour tenir compte des encombrements respectifs des différentes parties de l'appareil un jeu de cales d'écart tel que 35 peut être interposé entre le mât 13 et la couronne 11. Le talon 32 est alors fixé à une cale 36 qui vient directement s'appuyer sur la couronne 11.

Le montage préconisé de la molette, munie de sa tige filetée à laquelle est accroché le patin, dans le mât de la potence procure un avantage. Il est en effet possible, en prenant des molettes identiques et des tiges filetées identiques, de les assembler d'une manière telle que les patins se trouvent tous à une égale distance de leur molette. Dans ce but, on introduit les molettes dans leurs encoches respectives (introduction par l'encoche). On visse les tiges filetées jusqu'à ce que les porte-patins 18 viennent en butée contre le mât et le retour de mât. Puis par des nombres de tours égaux on déplace tous les patins d'un jeu. Il en résulte que lors de la mise en place des molettes ainsi assemblées dans les mâts la distance qui sépare le patin 16 du talon 32 est pour toutes les potences identique : il y a un transfert de la référence de réglage. La mise en place et le réglage du mandrin s'en trouvent alors grandement facilité : il suffit de tourner toutes les molettes de chaque jeu d'un même nombre de tours ou de fraction de tours. La précision du réglage dépend de la précision de la réalisation des surfaces de références 33 et 34.

Enfin dans l'invention les potences peuvent être munies chacune d'une tête amovible telle que la tête 37 de la potence 7. La tête 37 est par exemple fixée à l'extrémité du mât 7 au moyen d'une vis 38. Lors de l'installation le calage longitudinal du mandrin 4 est obtenu en venant abouter une de ses extrémités contre la tête 37. En définitive la face 39, tournée vers l'intérieur de l'appareil, de la tête 37 est une translation de la face de référence 33 de la couronne 11. Dès que les molettes 21 ont été actionnées pour mettre sous contrainte le mandrin 4, les têtes 37 peuvent être otées de manière à limiter la transmission des vibrations du mandrin 4 à la potence. Ceci limite le bruit tout en procurant par ailleurs la rigidité d'une référence ferme. La réduction des vibrations et de leurs effets est donc dans l'invention tout à fait comptatible avec la précision de la mise en place.

En outre le mandrin 4 est de préférence du type monobloc. Ceci signifie que les bobines de gradient qui y sont installées en sont rendues solidaires le plus continuement possible. En particulier la fixation de ces bobines est assortie d'un surmoulage du mandrin dans de la résine polymérisable. Après polymérisation le mandrin 4 en entier, monobloc, est plus particulièrement susceptible d'osciller entre ses appuis (de part et d'autre de l'aimant) à une fréquence propre. Le matériau amortisseur des patins 16 est de préférence calculé pour amortir des vibrations à cette fréquence. Ceci n'est pas possible dans l'état de la technique évoqué où le mandrin en outre non monobloc émet un spectre large de vibrations qu'il est difficile d'atténuer. Ceci est encore plus critique si le résonnateur mécanique qu'il constitue vient se coupler à un autre résonnateur, les bobines de shim, et qu'ils excitent mécaniquement en commun l'aimant. Dans un exemple les patins 16 sont réalisés en caoutchouc.

## Revendications

1 - Dispositif de fixation et de réglage d'un mandrin (4) porteur de bobines de gradient à l'intérieur d'un aimant (2), en forme générale de tube, d'un appareil de mesure de la résonance magnétique nucléaire, caractérisé en ce qu'il comporte deux jeux (7-8,9-10) de potences identiques, distribuées et fixées radialement par leur mât (13) de part et d'autre sur des couronnes extrêmes (11,12) du tube de l'aimant, chaque potence étant munie dans son bras (14) de moyens de mise en contrainte du mandrin.

2 - Dispositif selon la revendication 1, caractérisé en ce que les moyens de mise en contrainte comportent des moyens (16-28) pour exercer une contrainte orientée vers l'intérieur (1) du mandrin.

3 - Dispositif selon l'une quelconque des revendications 1 ou 2, caractérisé en ce que les moyens de mise en contrainte comportent un patin (16) emmené par une tige filetée (17) fixe en rotation et une molette de manoeuvre (21) fixe en translation par rapport à la potence pour déplacer la tige filetée radialement au tube.

4 - Dispositif selon la revendication 3, caractérisé en ce que les patins comportent une partie en caoutchouc au contact du mandrin.

5 - Dispositif selon l'une quelconque des revendications 1 à 4, caractérisé en ce que les mâts des potences comportent tous un talon (32) placé en un même endroit sur le mât pour venir s'appuyer sur une face intérieure du tube de l'aimant, et une ouverture oblongue (30) dans le mât pour favoriser la fixation de la potence sur la couronne extrême en respectant des variations de fabrication.

6 - Dispositif selon l'une quelconque des revendications 1 à 5, caractérisé en ce que les mâts de potence comportent en outre une tête (37) qui dépasse de la potence pour servir de butée de réglage longitudinal du mandrin.

7 - Dispositif selon la revendication 6, caractérisé en ce que les têtes sont amovibles (38) pour réduire les bruits.

8 - Dispositif selon l'une quelconque des revendications 1 à 8, caractérisé en ce que les mâts des potences sont fixés à l'extrémité du tube au moyen de cales (35) d'écart.

9 - Dispositif selon l'une quelconque des revendications 1 à 8, caractérisé en ce que chaque jeu de potences comporte 6 potences régulièrement réparties sur chaque couronne extrême.

10 - Dispositif selon l'une quelconque des revendications 1 à 9, caractérisé en ce que l'aimant comporte un mandrin de gradient monobloc.

## Patentansprüche

1. Vorrichtung zur Befestigung und Einstellung eines Gradientenspulen-Trägerkörpers (4) innerhalb eines Magnetes (2), allgemein im Rohrform, bei einem Gerät zum Messen der magnetischen Kernresonanz, dadurch gekennzeichnet, daß sie zwei Sätze (7–8, 9–10) von untereinander gleichen Auslegern umfaßt, die beiderseits auf Endkränzen (11, 12) des Magnetrohres verteilt und durch ihren Pfosten (13) radial befestigt sind, wobei jeder Ausleger in seinem Auslegerarm (14) Mittel zur Beanspruchung des Trägerkörpers umfaßt.

2. Vorrichtung nach Anspruch 1, dadurch gekennzeichnet, daß die Mittel zur Beanspruchung Mittel (16–28) umfassen, um eine zum Inneren (1) des Trägerkörpers hin eingestellte Beanspruchung auszuüben.

3. Vorrichtung nach Anspruch 1 oder 2, dadurch gekennzeichnet, daß die Mittel zur Beanspruchung eine Kufe (16) umfassen, die von einer in Rotation festen Gewindestange (17) und von einem in bezug auf den Ausleger in Translation festen gerändelten Betätigungsrad (21) geführt wird, um die Gewindestange radial zum Rohr zu verschieben.

4. Vorrichtung nach Anspruch 3, dadurch gekennzeichnet, daß die Kufen einen Teil aus Gummi, der mit dem Trägerkörper in Berührung steht, umfassen.

5. Vorrichtung nach einem der Ansprüche 1 bis 4, dadurch gekennzeichnet, daß alle Pfosten der Ausleger einen Absatz (32), der an einer selben Stelle auf dem Pfosten angeordnet ist, um sich auf einer Innenfläche des Magnetrohres abzustützen, sowie eine längliche Öffnung (30) in dem Pfosten umfassen, um die Befestigung des Auslegers auf dem Endkranz unter Berücksichtigung von Fabrikationsänderungen zu begünstigen.

6. Vorrichtung nach einem der Ansprüche 1 bis 5, dadurch gekennzeichnet, daß die Pfosten der Ausleger ferner einen Kopf (37) umfassen, der aus dem Ausleger herausragt, um als Anschlag zur Längseinstellung des Trägerkörpers zu dienen.

7. Vorrichtung nach Anspruch 6, dadurch gekennzeichnet, daß die Köpfe entfernbar (38) sind, um die Geräusche zu verringern.

8. Vorrichtung nach einem der Ansprüche 1 bis 7, dadurch gekennzeichnet, daß die Pfosten der Ausleger am Ende des Rohres mittels Abstandskeilen (35) befestigt sind.

9. Vorrichtung nach einem der Ansprüche 1 bis 8, dadurch gekennzeichnet, daß jeder Auslegersatz 6 Ausleger umfaßt, die auf jedem Endkranz gleichmäßig verteilt sind.

10. Vorrichtung nach einem der Ansprüche 1 bis 9, dadurch gekennzeichnet, daß der Magnet einen einstückigen Gradient-Trägerkörper umfaßt.

## Claims

1. A device for locating and adjusting a mandril (4) carrying gradient coils in the interior of a magnet (2), generally in the form of a tube, of an apparatus for measuring nuclear magnetic resonance, characterized in that it comprises two sets (7 and 8, 9 and 10) of equal hangers, distributed and radially secured by their mast (13) at both ends on end crowns (11 and 12) of the tube of the magnet, each hanger having means for clamping the mandril in its arm (14).

2. The device as claimed in claim 1 characterized in that the clamping means comprise means (16 through 28) in order to exert a clamping force directed towards the interior (1) of the mandril.

3. The device as claimed in claim 1 or in claim 2 characterized in that the clamping means comprise a shoe (16) running on a threaded rod (17) and locked in rotation and a maneuvering wheel (21) locked in translation in relation to the hanger in order to displace the threaded rod radially in relation to the tube.

4. The device as claimed in claim 3 characterized in that the shoes comprise a part made of rubber in contact with the mandril.

5. The device as claimed in any one of the claims 1 through 4 characterized in that masts of the hangers all comprise a heel (32) placed at a common position on the mast in order to bear against an interior face of the tube of the magnet and an oblong orifice (30) in the mast in order to facilitate fixing the hanger on the end crown while allowing for manufacturing inaccuracies.

6. The device as claimed in any one of the claims 1 through 5 characterized in that the hanger masts furthermore comprise a head (27) which extends past the hanger in order to serve as an abutment for longitudinal adjustment of the mandril.

7. The device as claimed in claim 6 characterized in that the heads (38) are able to be moved into order to reduce noise.

8. The device as claimed in any one of the claims 1 through 8 characterized in that the masts of the hangers are fixed to the end of the tube by means of spacing shims (35).

9. The device as claimed in any one of the claims 1 through 8 characterized in that each set of hangers comprises 6 hangers regularly spaced on each end crown.

10. The device as claimed in any one of the claims 1 through 9 characterized in that the magnet comprises a monoblock gradient mandril.

# FIG_1

$B_0$

# FIG_3

FIG_2